**Europäisches Patentamt**

**European Patent Office**

**Office européen des brevets**

(19)

(11) Veröffentlichungsnummer : **0 135 845**
**B1**

(12)　　　　　．　　　　**EUROPÄISCHE PATENTSCHRIFT**

(45) Veröffentlichungstag der Patentschrift :
23.03.88

(51) Int. Cl.⁴ : **F 16 F 15/00, F 16 B 1/00**

(21) Anmeldenummer : **84110393.0**

(22) Anmeldetag : **31.08.84**

(54) Vorrichtung zur Befestigung eines zwei im Abstand hintereinander angeordnete Tragflansche aufweisenden Gerätes.

(30) Priorität : **19.09.83 DE 8326902 U**

(43) Veröffentlichungstag der Anmeldung :
**03.04.85 Patentblatt 85/14**

(45) Bekanntmachung des Hinweises auf die Patenterteilung : **23.03.88 Patentblatt 88/12**

(84) Benannte Vertragsstaaten :
**AT BE CH DE FR GB IT LI LU NL SE**

(56) Entgegenhaltungen :
**DE-U- 1 998 332**
**GB-A- 839 311**

(73) Patentinhaber : **Nixdorf Computer Aktiengesellschaft**
**Fürstenallee 7**
**D-4790 Paderborn (DE)**

(72) Erfinder : **Haftmann, Johannes**
**Wasserwerkstrasse 29**
**D-4795 Delbrück-Ostenland (DE)**

(74) Vertreter : **Patentanwälte Schaumburg & Thoenes**
**Mauerkircherstrasse 31 Postfach 86 07 48**
**D-8000 München 80 (DE)**

## Beschreibung

Die Neuerung betrifft eine Vorrichtung, der im Oberbegriff des Anspruches 1 genannten Art.

Als typische Beispiele für mit zwei Tragflanschen ausgestattete Geräte können Axiallüfter angesehen werden, wie sie beispielsweise als Kühlgebläse in die Gerätegehäuse von elektrischen oder elektronischen Geräten eingebaut werden. Diese Axiallüfter besitzen im allgemeinen ein etwa rohrförmiges Lüftergehäuse, in welchem über speichenartige Befestigungsstreben die Lüfternabe mit dem Lüfterrad angeordnet ist. Die beiden Tragflansche sind jeweils an den Stirnseiten des Lüftergehäuses quer zur Lüfterachse angeordnet.

Derartige Axiallüfter oder andere Geräte der gattungsgemäßen Art werden überlicherweise mit Schrauben an dem anderen Bauteil, beispielsweise einer Gehäusewand, befestigt, wobei die Schrauben durch in den Tragflanschen ausgebildete Bohrungen greifen. Dies führt dazu, daß beispielsweise von dem Gerät erzeugte Geräusche als Körperschall auf das andere Bauteil übertragen werden, wobei sich oft durch Resonanzerscheinungen bzw. durch eine großflächige Geräuschabstrahlung über das andere Bauteil eine Verstärkung der Geräusche einstellt. Im Falle der beschriebenen Lüfter äußert sich das als störendes Brummen.

Es ist auch schon bekannt, derartige Geräte über sogenannte Schwingmetalle mit dem Gehäuse zu verbinden.

Der Einsatz dieser Schwingmetalle brachte jedoch zwei Nachteile mit sich. Einerseits ist gegenüber der direkten Befestigung der Montageaufwand wesentlich größer, andererseits ergibt sich ein erhöhter Platzbedarf etwa um die Stärke der zwischen dem Gerät und dem dieses aufnehmenden Bauteil angeordneten Schwingmetall.

Eine speziell bei Lüftern verwendete Befestigungsart besteht darin, den Lüfter unter eine aus der Gehäusewand vorstehende Metall-Lasche zu klemmen, wobei zwischen diese Lasche und den Lüfter schwingungsdämpfendes Material, z. B. Schaumgummiplatten, gelegt werden, um eine Resonanzübertragung zu vermeiden. Auch diese Lösung erfordert einen beachtlichen Montage- und Demontageaufwand, so daß beispielsweise beim Auswechseln eines defekten Lüfters im allgemeinen das gesamte den Lüfter tragende Bauteil demontiert werden muß.

Es ist auch bereits eine schwingungsdämpfende Aufhängung für Lüfter bekannt, bei der außen auf ein den Lüftermotor umgebenden kreisringförmigen Tragring etwa keilförmige Spannstücke aufgesetzt werden, welche dann zusammen mit dem Lüftermotor axial in einen ebenfalls im wesentlichen kreisringförmigen Haltering eingeschoben werden, wobei die Spannstücke zwischen Tragring und Haltering eingeklemmt werden und so eine schwingungsdämpfende Halterung bilden (DE-U-1 998 332). Diese Aufhängeeinrichtung ist ganz speziell für die Befestigung zwischen zwei kreisringförmigen Ringen ausgelegt, wobei ein für eine axiale Montage ausreichender Platz vor bzw. hinter dem Montageort des Lüftermotors vorgesehen sein muß. Für die Montage eines Gerätes gemäß dem Oberbegriff des Anspruches 1 ist die bekannte Einrichtung nicht geeignet.

Es ist die Aufgabe der vorliegenden Erfindung, eine Vorrichtung zu schaffen, welche eine einfache, platzsparende Befestigung für Geräte der gattungsgemäßen Art ermöglicht und welche eine wirksame Schwingungsdämpfung zwischen dem Gerät und dem dieses aufnehmenden Bauteil sicherstellt.

Diese Aufgabe ist durch die im Kennzeichen des Anspruches 1 beschriebenen Merkmale gelöst.

Das Befestigungselement greift mit der Haltestrebe zwischen die Tragflansche, so daß der erforderliche Einbauraum in axiale Richtung nicht über die Gerätelänge hinaus vergrößert wird. Mit der Haltestrebe ist über einen oder mehrere Verbindungsstege eine Lasche oder dgl. verbunden, an deren dem aufnehmenden Bauteil zugewandten Fläche Befestigungsmittel angeordnet sind, über die die Verbindung zu diesem Bauteil erfolgt. Die Verbindungsstege, die Lasche oder beide bestehen aus einem elastischen Material, so daß die von dem Gerät erzeugten Schwingungen und Geräusche nicht auf das dieses aufnehmende Bauteil übertragen werden können. Als elastisches Material kann beispielsweise ein PU-Elastomer dienen.

In einer bevorzugten Ausgestaltung der Erfindung weist die Lasche eine den Abstand der beiden Tragflansche überbrückende Länge auf derart, daß sie sich bei der Montage des Befestigungselementes auf die Außenkanten der beiden Tragflansche auflegt. Wegen der Elastizität der Verbindungsstege und/oder der Lasche ergibt sich dabei eine gute Ausrichtung und Fixierung des Befestigungselementes gegenüber den Tragflanschen.

Eine besonders einfache Verbindung zwischen dem Befestigungselement und den Tragflanschen ergibt sich gemäß der Erfindung dann, wenn an den Enden der Haltestrebe Fortsätze ausgebildet sind, welche in an den Tragflanschen ausgebildete Durchbrechungen eingreifen. Die Montage der Befestigungselemente kann entweder schon beim Zusammenbau des Gerätes erfolgen oder in der Weise, daß die Haltestrebe einfach zwischen die Tragflansche geschoben wird, wobei diese elastisch ausweichen und/oder — wie weiter hinten beschrieben — die Haltestrebe selbst in axialer Richtung zusammendrückbar ist.

In einer bevorzugten Ausgestaltung der Erfindung ist das gesamte Befestigungselement einstückig aus einem elastischen Kunststoffmaterial ausgebildet.

Die Tragflansche sind im allgemeinen vieleckig, speziell rechteckig ausgebildet. Es ist dann gemäß der Erfindung vorgesehen, daß die Lasche die Form eines zweischenkligen Winkels mit einem der Form der jeweils zugeordneten Flanschecken entsprechenden Querschnittsprofil aufweist. Die Lasche schmiegt sich dann von außen an die Flanschecken an, so daß sich eine exakte Ausrichtung sowie Fixierung der Befestigungselemente an den Tragflanschen ergibt. Bei dieser beschriebenen Ausbildung ist vorgesehen, daß jeder Schenkel der Lasche jeweils über einen Verbindungssteg mit der Haltestrebe verbunden ist. Bei der vorzugsweise verwendeten rechteckigen Tragflanschform mit abgerundeten Ecken sind dann auch die Schenkel der Befestigungselemente rechtwinklig zueinander angeordnet und über einen etwa viertelkreisförmigen Bogen miteinander verbunden.

Die an der Lasche ausgebildeten Befestigungsmittel können von jeder beliebigen Form sein, die eine Befestigung an dem das Gerät aufnehmenden Bauteil erlaubt. Bei einer Ausgestaltung der Erfindung ist vorgesehen, daß an der Außenseite wenigstens eines Schenkels eine rampenartig ansteigende Rastnase angeordnet ist. Diese Ausführungsform ist insbesondere dazu geeignet, das Gerät zwischen zwei auf einer Gehäusewand senkrecht stehende, elastische Laschen einzurasten, wie weiter hinten genauer beschrieben wird. Bei einem anderen Ausführungsbeispiel der Erfindung ist an der Lasche wenigstens ein Rastnoppen o. dgl. angeordnet, welcher direkt in eine Gehäusewandbohrung einrasten kann. Diese Ausführungsform wird vorzugsweise für die sogenannte « liegende Montage » verwendet, bei der die Trageflansche etwa parallel zu einer Gehäusewand angeordnet sind. Dabei ist gemäß der Neuerung der Rastnoppen quer zur Ausrichtung der Schenkel der Lasche ausgerichtet, wie ebenfalls weiter hinten genauer beschrieben wird.

Mehrere Ausführungsbeispiele der Neuerung sind in der Zeichnung dargestellt und im folgenden näher beschrieben. Es zeigen :

Fig. 1 in perspektivischer Darstellung ein Befestigungselement, ein zu befestigendes Gerät sowie ein Bauteil zur Aufnahme dieses Gerätes ;

Fig. 2 bis verschiedene Ansichten eines Befestigungselementes gemäß Fig. 1 ;

Fig. 5 ein anderes Ausführungsbeispiel eines Befestigungselementes für die « liegende Befestigung » eines Gerätes ;

Fig. 6 ein weiteres Ausführungsbeispiel eines Befestigungselementes für die « liegende Befestigung » eines Gerätes ;

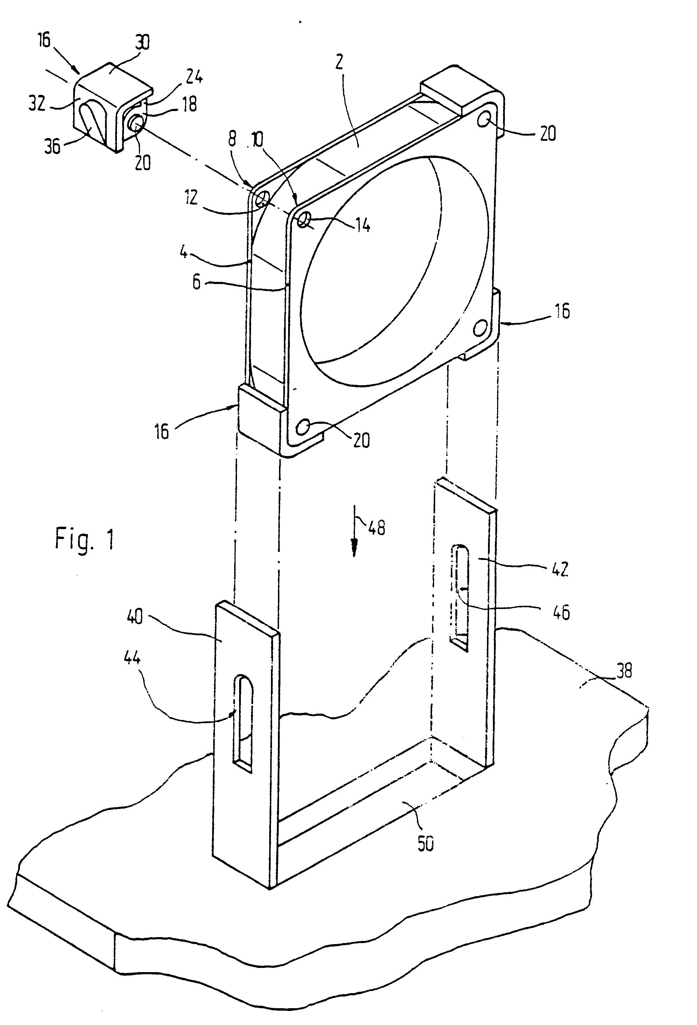

Fig. 1 zeigt ein etwa rohrförmiges Gehäuse 2 eines Axiallüfters mit an den beiden Stirnseiten des Gehäuses 2 angeordneten Tragflanschen 4, 6. Das Gehäuse 2 ist von herkömmlichem Aufbau. Der besseren Übersichtlichkeit wegen wurde auf die Darstellung der in diesem Gehäuse 2 angeordneten Baueinheit, bestehend aus Lüfternabe mit Antrieb sowie dem Lüfterrad, verzichtet. Wie erkennbar ist, stehen die beiden Tragflansche 4, 6 im Bereich ihrer Ecken, z. B. 8 und 10, über die Außenkontur des Gehäuses 2 über. Im Bereich der Flanschecken sind jeweils Durchbrechungen 12, 14 ausgebildet.

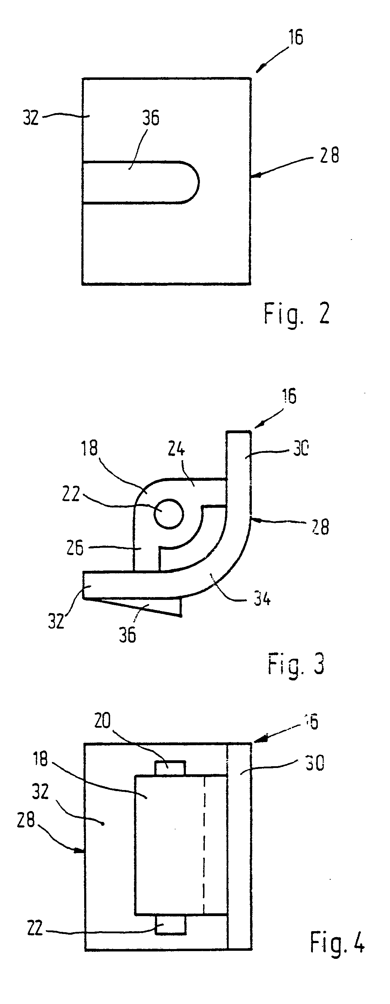

Wie insbesondere auch die Fig. 2 bis 4 zeigen, besteht das Befestigungselement 16 im wesentlichen aus einer Haltestrebe 18, deren Länge dem Innenabstand zwischen den Tragflanschen 4, 6 entspricht. An den Stirnseiten der Haltestrebe 18 sind jeweils Fortsätze 20, 22 ausgebildet, welche zum Eingriff in die Durchbrechungen 12, 14 bestimmt sind. Mit der Haltestrebe 18 ist über zwei Verbindungsstege 24, 26 eine Lasche 28 verbunden. Die Lasche 28 hat die Form eines zweischenkligen Winkels, dessen Schenkel 30, 32 rechtwinklig zueinander stehen und über einen etwa viertelkreisförmigen Bogen 34 miteinander verbunden sind. Die Breite der Lasche ist so gewählt, daß sich diese gegen die Außenkanten der Tragflansche 4, 6 legt, wie insbesondere die bereits montierten Befestigungselemente in Fig. 1 erkennen lassen. Die Lasche 28 ist so geformt, daß sie sich exakt an die Ecken der Tragflansche anschmiegt.

Am Schenkel 32 ist eine vom freien Ende dieses Schenkels aus in Richtung zu der die Schenkel verbindenden Ecke rampenartig ansteigende Rastnase 36 angeordnet. Auf einer Gehäusewand 38 sind zwei etwa senkrecht auf diese stehende Haltelaschen angeordnet. In den Haltelaschen 40, 42 sind jeweils langlochartige Ausnehmungen 44, 46 ausgebildet. In dem in Fig. 1 dargestellten Ausführungsbeispiel sind die beiden oberen Befestigungselemente 16 jeweils so ausgerichtet, daß sich die Rastnasen 36 jeweils an den seitlichen, mit den Haltelaschen 40, 42 in Berührung kommenden Schenkeln befinden. Die beiden unteren Befestigungselemente 16 sind dagegen so orientiert, daß die Rastnasen 36 in Montagerichtung 48 nach unten weisen, so daß sie auf dieser Darstellung nicht zu sehen sind.

Für die Montage wird das mit den Befestigungselementen 16 bestückte Gehäuse 2 in Richtung des Pfeiles 48 zwischen die Haltelaschen 40, 42 geschoben, wobei diese Haltelaschen durch die Rastnasen 36 auseinander gedrückt werden, bis diese in die Ausnehmungen 44, 46 einrasten, so daß das Gehäuse 2 in Richtung entgegen dem Pfeil 48 fixiert wird. In der Gehäusewand 38 kann zwischen den Haltelaschen 40, 42 eine Ausnehmung 50 ausgebildet sein, welche den unteren Teil des Gehäuses 2 aufnimmt und für eine zusätzliche Fixierung sorgt.

Die Befestigungselemente 16 sind einstückig aus einem elastischen Material ausgebildet. Zur Montage kann die Haltestrebe 18 soweit zusammengedrückt werden, daß sich die Vorsprünge 20, 22 zwischen die Tragflansche 4, 6 schieben lassen, bis sie elastisch in die Durchbrechungen 12, 14 einschnappen. Da die Laschen 28 ebenfalls aus elastischem Material bestehen, übertragen sie auch dann keine Schwingungen an die Gehäusewand 38, wenn sie direkt auf dieser aufliegen.

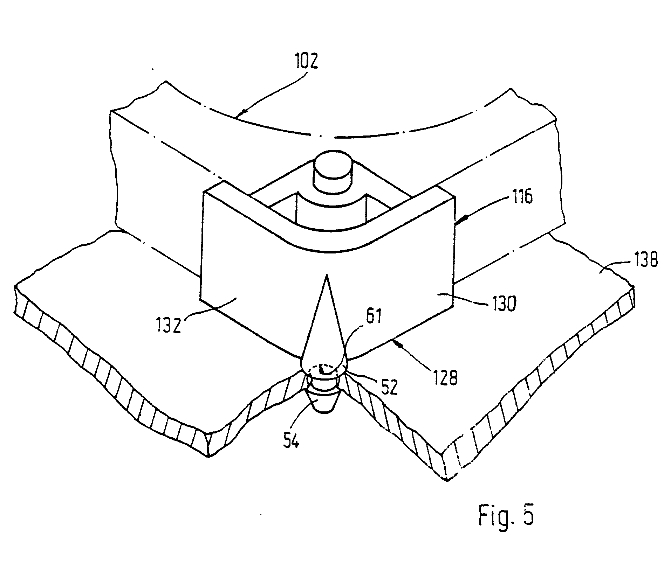

Fig. 5 zeigt ein Befestigungselement 116, welches in seinen wesentlichen Teilen den Befestigungselementen 16 entspricht und deshalb im einzelnen nicht noch einmal beschrieben zu werden braucht. An einem an der Außenseite der Lasche 128 ausgeformten Materialwulst 52 ist ein quer zur Erstreckung der Schenkel 130, 132, d. h. also parallel zur Lüfterachse gerichteter Rastnoppen 54 ausgebildet, welcher in an sich bekannter Weise unter elastischer Verformung in eine in der Gehäusewand 138 ausgebildete Gehäusewandbohrung eingreifen kann. Diese Anordnung eignet sich insbesondere zur liegenden Befestigung des Gehäuses 102. Damit das Gehäuse 102 nicht mit der Wand 138 direkt in Berührung kommt, kann entweder die Lasche 128 etwas breiter sein als das Gehäuse 102, oder der Materialwulst 52 ist etwas über die Seitenkante der Lasche 128 hinausgezogen.

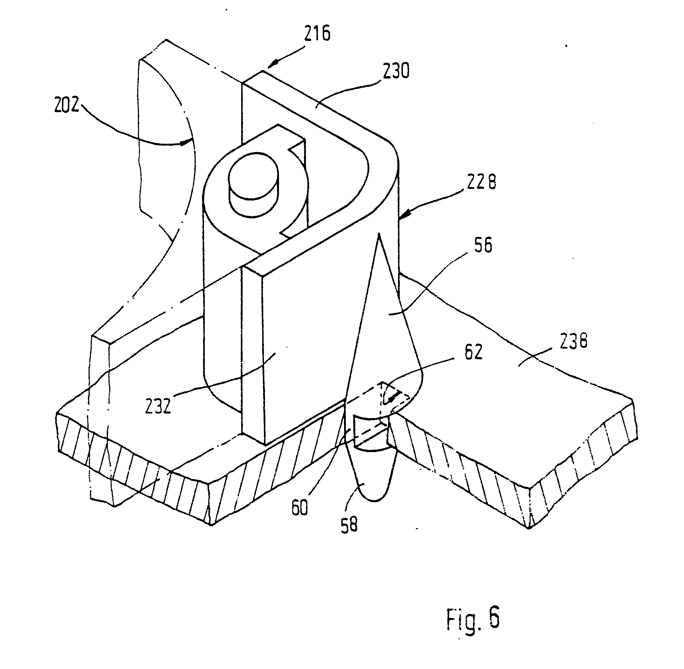

Fig. 6 zeigt ein Befestigungselement 216, welches im wesentlichen dem in Fig. 5 dargestellten Befestigungselement 116 entspricht. Es unterscheidet sich von diesem im wesentlichen dadurch, daß an dem Materialwulst 56 ein Rastnoppen 58 über einen elastisch verbiegbaren Steg 60 befestigt ist. Zur Montage des mit den Befestigungselementen 216 bestückten Gehäuses 202 werden die Rastnoppen 58 in an sich bekannter Weise in die zugeordneten, diesen gegenüber leicht versetzten Gehäusewandöffnungen eingeführt, so daß die Rastnoppen 58 elastisch zur Seite gedrückt werden, bis sie die Gehäusewand 238 passiert haben und elastisch hinter dieser einrasten. Diese Ausführungsform erlaubt eine einfache Demontage des Gerätes bzw. Gehäuses 202, in dem die Rastnoppen 58 elastisch zur Seite gedrückt werden, bis sie durch die Gehäusewandöffnungen 62 heraustreten können.

**Patentansprüche**

1. Vorrichtung zur Befestigung eines zwei im Abstand voneinander angeordnete, einander gegenüberstehende Tragflansche aufweisenden Gerätes an einem anderen Bauteil (38, 138, 238) gekennzeichnet durch ein Befestigungselement mit einer zwischen die Tragflansche (4, 6) einsetzbaren, mit diesen verbindbaren Haltestrebe (18) sowie einer über wenigstens einen Verbindungssteg (24, 26) mit der Haltestrebe (18) verbundenen Lasche (28, 128, 228), an welcher Befestigungsmittel (36, 54, 58) zum Befestigen derselben am anderen Bauteil (38, 138, 238) angeordnet sind, wobei die Verbindungsstege (24, 26) und/oder die Lasche (28, 128, 228) aus einem elastischen Material bestehen.

2. Vorrichtung nach Anspruch 1, dadurch gekennzeichnet, daß die Lasche (28, 128, 228) eine den Abstand der beiden Tragflansche (4, 6) überbrückende Länge aufweist und auf die Außenkanten der beiden Tragflansche (4, 6) auflegbar ist.

3. Vorrichtung nach einem der Ansprüche 1 oder 2, dadurch gekennzeichnet, daß an den Enden der Haltestrebe (18) Fortsätze (22, 24) ausgebildet sind, welche in an den Tragflanschen (4, 6) ausgebildete Durchbrechungen (12, 14) eingreifen.

4. Vorrichtung nach einem der Ansprüche 1 bis 3, dadurch gekennzeichnet, daß diese einstückig aus einem elastischen Kunststoffmaterial ausgebildet ist.

5. Vorrichtung nach einem der Ansprüche 1 bis 4 für Geräte mit vieleckigen Tragflanschen, dadurch gekennzeichnet, daß die Lasche (28, 128, 228) die Form eines zweischenkligen Winkels mit einem der Form einer jeweils zugeordneten Flanschecke (8, 10) entsprechenden Querschnittprofil aufweist.

6. Vorrichtung nach Anspruch 5, dadurch gekennzeichnet, daß jeder Schenkel (30, 32 ; 130, 132 ; 230, 232) der Lasche (28, 128, 228) jeweils über einen Verbindungssteg (24, 26) mit der Haltestrebe (18) verbunden ist.

7. Vorrichtung nach Anspruch 5 oder 6, dadurch gekennzeichnet, daß an der Außenseite wenigstens eines Schenkels (32) eine rampenartig ansteigende Rastnase (36) angeordnet ist.

8. Vorrichtung nach Anspruch 7, dadurch gekennzeichnet, daß die Rastnase (36) vom freien Ende des Schenkels (32) aus in Richtung zu der die Schenkel (30, 32) verbindenden Ecke einsteigt.

9. Vorrichtung nach Anspruch 5 oder 6, dadurch gekennzeichnet, daß an der Lasche (128, 228) wenigstens ein zum Eingriff in eine Gehäusewandöffnung (61, 62) oder dgl. ausgebildeter Rastnoppen (54, 58) oder dgl. angeordnet ist.

10. Vorrichtung nach Anspruch 9, dadurch gekennzeichnet, daß der Rastnoppen (54, 58) quer zur Richtung der Schenkelerstreckung ausgerichtet ist.

**Claims**

1. Device for the fastening of a unit to another member (38, 138, 238), said unit having two spaced supporting flanges arranged opposite to each other, characterized by a fastening element with a retaining brace (18) adapted to be mounted between the supporting flanges (4, 6) and connected with them, and with a strip (28, 128, 228) connected by at least one connecting arm (24, 26) with the retaining brace (18), on to which strip are arranged fastening means (36, 54, 58) for fastening the brace (18) to said other member (38, 138, 238), wherein the connecting arms (24, 26) and/or the strip (28, 128, 228) consists of an elastomeric material.

2. Device as claimed in Claim 1, characterized in that the strip (28, 128, 228) has a length bridging the spacing between the two supporting flanges (4, 6) and can be placed on the outer edges of the two supporting flanges (4, 6).

3. Device as claimed in Claim 1 or 2, characterized in that extensions (20, 22) which engage in openings (12, 14) formed on the supporting flanges (4, 6) are formed on the ends of the retaining brace (18).

4. Device as claimed in one of claims 1 to 3, characterized in that this device is made in one piece of an elastic plastic material.

5. Device as claimed in one of claims 1 to 4 for units with polygonal supporting flanges, characterized in that the strip (28, 128, 228) is formed in the shape of a two-sided angle with a cross section shape corresponding to the shape of a flange corner (8, 10) with which said strip is peratively associated.

6. Device as claimed in Claim 5, characterized in that each side (30, 32 ; 130, 132 ; 230, 232) of the strip (28, 128, 228) is respectively connected with the retaining brace (18) by means of a connecting arm (24, 26).

7. Device as claimed in Claim 5 or 6, characterized in that a locking catch (36) rising like a ramp is arranged on the outside of at least one side (32).

8. Device as claimed in Claim 7, characterized in that the catch (36) runs out from the free end of the side (32) in the direction of the corner connecting the sides (30, 32).

9. Fastening element as claimed in Claim 5 or 6, characterized in that at least one lock knob (54, 58) or the like for engaging in an opening (61, 62) or the like in a housing wall is arranged on the strip (128, 228).

10. Fastening element as claimed in Claim 9, characterized in that the lock knob (54, 58) is aligned transversely to the direction of the extent of the sides.

**Revendications**

1. Dispositif pour la fixation à une autre pièce (38, 138, 238) d'un appareil ayant deux brides porteuses disposées à distance l'une de l'autre, opposées l'une à l'autre, caractérisé par un élément de fixation comprenant une entretoise d'appui (18) pouvant être introduite entre les brides porteuses (4, 6) et pouvant être réunie à celles-ci, ainsi qu'une éclisse (28, 128, 228) reliée à l'entretoise d'appui (18) par au moins une nervure de liaison (24, 26) et sur laquelle sont disposés des moyens de fixation (36, 54, 58) pour sa fixation à l'autre pièce (38, 138, 238), les nervures de liaison (24, 26) et/ou l'éclisse (28, 128, 228) étant réalisées en matière élastique.

2. Dispositif selon la revendication 1, caractérisé en ce que l'éclisse (28, 128, 228) présente une longueur couvrant la distance entre les deux brides porteuses (4, 6) et peut être placée contre les bords extérieurs des deux brides porteuses (4, 6).

3. Dispositif selon la revendication 1 ou 2, caractérisé en ce qu'il est formé aux extrémités de l'entretoise d'appui (18) des prolongements (20, 22) aptes à pénétrer dans des logements (12, 14) prévus dans les brides porteuses (4, 6).

4. Dispositif selon l'une des revendications 1 à 3, caractérisé en ce qu'il est composé d'une seule pièce en matière plastique élastique.

5. Dispositif selon l'une des revendications 1 à 4 pour des appareils à brides porteuses polygonales, caractérisé en ce que l'éclisse (28, 128, 228) présente la forme d'une équerre à deux branches avec un profil en section droite qui correspond à la forme d'un sommet de bride (8, 10) correspondant respectif.

6. Dispositif selon la revendication 5, caractérisé en ce que chaque branche (30, 32 ; 130, 132 ; 230, 232) de l'éclisse (28, 128, 228) est réunie par une nervure de liaison respective (24, 26) à l'entretoise d'appui (18).

7. Dispositif selon la revendication 5 ou 6, caractérisé en ce que sur la face extérieure d'au moins une branche (32) est disposé un ergot d'arrêt (36) montant à la façon d'une rampe.

8. Dispositif selon la revendication 7, caractérisé en ce que l'ergot d'arrêt (36) monte à partir de l'extrémité libre de la branche (32) en direction du sommet reliant les branches (30, 32).

9. Dispositif selon la revendication 5 ou 6, caractérisé en ce qu'au moins un bouton de retenue (54, 58) ou analogue conformé pour s'engager dans une ouverture (61, 62) de la paroi du boîtier ou analogue est placé sur l'éclisse (128, 228).

10. Dispositif selon la revendication 9, caractérisé en ce que le bouton de retenue (54, 58) est orienté en sens transversal à la direction le long de laquelle s'étendent les branches.

Fig. 1

Fig. 2

Fig. 3

Fig. 4

Fig. 5

Fig. 6